# EUROPÄISCHE PATENTANMELDUNG

(11) **EP 1 001 207 A1**
(43) Veröffentlichungstag der Anmeldung: **17.05.2000**
(21) Anmeldenummer: 99118703.0
(22) Anmeldetag: 22.09.1999
(51) Int. Cl.: F16M 7/00

(54) **Aufstellfuss für ein Gehäuse**

(30) Priorität: 09.11.1998 DE 19851587
(71) Anmelder: VERO Electronics GmbH, 28279 Bremen (DE)
(72) Erfinder: Schröder, Rainer, 27721 Ritterhude (DE)
(74) Vertreter: Bohnenberger, Johannes, Dr.

(57) **Zusammenfassung**

Die Erfindung betrifft einen Aufstellfuß (2) für ein Gehäuse, insbesondere für ein 19"-Tischgehäuse.

Erfindungsgemäß wird ein kostengünstig herstellbarer Aufstellfuß vorgeschlagen, der zudem einfach und schnell montiert werden kann, der ein an einer Seitenwand (1) des Gehäuses befestigbares Basisteil (3) aufweist, wobei das Basisteil an seinem oberen Ende eine erste Fußfläche (5) und an seinem unteren Ende eine zweite Fußfläche (6) und mindestens eine Öffnung (12, 13) zum Durchgriff eines Befestigungselements (14) zur Befestigung des Basisteils (3) an der Seitenwand (1) des Gehäuses aufweist und bei dem die Öffnung außermittig zwischen der ersten und der zweiten Fußfläche (5, 6) angeordnet ist.

## Beschreibung

Die Erfindung betrifft einen Aufstellfuß für ein Gehäuse, insbesondere für ein 19"-Tischgehäuse entsprechend dem Oberbegriff des Anspruchs 1.

Auf Leiterplatten vorgesehene elektronische Bauelemente werden üblicherweise in Gehäusen untergebracht, die oftmals an ihren Frontseiten mit Anzeigeinstrumenten und Bedienungselementen versehen sind. Steht ein solches Gehäuse unmittelbar auf einer Unterlage, wie z. B. auf einem Tisch, so sind die untersten auf der Frontseite des Gehäuses angeordneten Bedienungselemente oft nur schwer zugänglich und die Anzeigeinstrumente nur schwer ablesbar. Daher werden entsprechende Gehäuse in der Regel mit Aufstellfüßen versehen, die auf die Gehäuseunterseite aufgeschraubt sind. Zur Verbesserung der Ablesbarkeit von Anzeigeinstrumenten und dergleichen werden beim bekannten Stand der Technik auch Aufstellfüße verwendet, die es erlauben, daß das Gehäuse schräg nach oben weist.

So ist aus der DE-C1-40 13 644 ein Gehäuse-Aufstellfuß bekannt, der ein Lager zum schwenkbeweglichen Lagern des Aufstellfußes aufweist, wobei das Lager so ausgebildet ist, daß der Aufstellfuß zwischen einer Null-Position, in welcher er im wesentlichen vollständig in einem Gehäuse aufgenommen wird, und einer Aufstellposition verschwenkbar ist. In der Aufstellposition ragt eine Fußfläche des bekannten Aufstellfußes aus dem Gehäuse heraus, so daß das Gehäuse auf einer Unterlage aufstellbar ist.

Unter der Bezeichnung KM7 wird von der Anmelderin ein Gehäuse vertrieben, das Aufstellfüße aufweist, die an einer Seitenwand eines Gehäuses mittels eines Lagers schwenkbar angebracht sind.

Weiterhin ist aus der US 40 68 815 ein Aufstellfuß für ein Gehäuse bekannt, wobei dieser bekannte Aufstellfuß insbesondere für eine Waschmaschine verwendet werden soll. Der exzentrische, um eine Drehachse verschwenkbare bekannte Aufstellfuß ist derart ausgebildet, daß ein "selbsttätiges" Angleichen der Aufstellhöhe gewährleistet ist, so daß die Waschmaschine (z. B. im Schleuderbetrieb) nicht wackelt. Bei diesem Aufstellfuß wird es als nachteilig angesehen, daß eine exakte Höhenpositionierung nur sehr schwer einstellbar ist.

An diesen bekannten Aufstellfüßen, die allesamt verschwenkbar zur Positionierung eines Gehäuses in zwei Positionen unterschiedlicher Höhe gestaltet sind, ist von Nachteil, daß diese relativ aufwendig und damit verhältnismäßig teuer sind. Ein solcher Aufwand wird insbesondere dann als wenig zweckmäßig angesehen, wenn das Gehäuse nur relativ selten in eine schräg nach oben weisende Stellung zur leichteren Ablesbarkeit von Anzeigeinstrumenten, Bedienungselementen und dergleichen gebracht werden soll.

Daher liegt der Erfindung die Aufgabe zugrunde, einen Aufstellfuß der eingangs genannten Art dahingehend weiterzubilden, daß dieser preisgünstig herstellbar und mit wenig Aufwand am Gehäuse montierbar ist.

Diese Aufgabe wird bei einem gattungsgemäßen Aufstellfuß durch die im Kennzeichen des Patentanspruchs 1 angegebenen Merkmale gelöst.

Ein erster wesentlicher Aspekt der Erfindung besteht darin, den Aufstellfuß so zu gestalten, daß er zwei, vorzugsweise einander gegenüberliegende Fußflächen aufweist, und daß zwischen den beiden Fußflächen mindestens eine Öffnung vorgesehen ist, deren Abstand von der ersten Fußfläche kleiner als von der zweiten Fußfläche ist, und die von einem Befestigungselement, wie insbesondere von einer Schraube, durchgriffen wird und den erfindungsgemäßen Aufstellfuß an der Seitenwand eines Gehäuses befestigt. Bei der Auslieferung eines mit erfindungsgemäßen Aufstellfüßen versehenen Gehäuses, können diese allesamt so an den unteren Enden der Seitenwände des Gehäuses angebracht sein, daß die Unterseite des Gehäuses parallel zur Tischebene verläuft, auf die das Gehäuse gestellt wird. Ergibt sich nun die Notwendigkeit, daß die Unterseite des Gehäuses schräg nach oben weisen soll, so kann das den betreffenden Aufstellfüßen zugeordnete Befestigungselement gelöst werden, die Aufstellfüße werden von den Seitenwänden des Gehäuses abgenommen und in einer um 180° verdrehten Position an den Seitenflächen des Gehäuses befestigt bzw. angeschraubt.

Ein solcher Kunststoff- oder Aluminium-Aufstellfuß kann preisgünstig in einem Kunststoff-Spritzguß- oder Aluminium-Spritzgußverfahren hergestellt werden. Es versteht sich, daß auch andere geeignete Materialien zur Herstellung des erfindungsgemäßen Aufstellfußes Verwendung finden können.

Gemäß einem weiteren wesentlichen Aspekt der Erfindung ist vorgesehen, den Aufstellfuß an seinem oberen und unteren Ende jeweils mit einem Zapfen oder dergleichen zu versehen, wobei jeweils ein Ringkörper, wie insbesondere ein Gummiring, über den Zapfen geschoben ist und diesen umschließt. Die vorzugsweise elastischen Ringkörper bilden das untere bzw. obere Ende des Aufstellfußes und gewährleisten, daß der Aufstellfuß sowohl in seiner Null-Position als auch in seiner Aufstell-Position weitgehend verhindert, daß das Gehäuse auf der Unterlage hin- und herrutscht. Durch die erfindungsgemäße Anordnung eines Zapfens oder dergleichen, der von einem Ringkörper umschlossen ist, kann ein Aufstellfuß hergestellt werden, der kostengünstig und leicht zusammenfügbar ist und dennoch wirksam ein Verrutschen des Gehäuses verhindert.

Nach einem dritten wesentlichen Aspekt der Erfindung ist vorgesehen, den Aufstellfuß mit einem Stützkörper zu versehen, auf dem sich die Unterfläche der betreffenden Seitenwand, an die der erfindungsgemäße Aufstellfuß befestigt ist, abstützt. In analoger Weise kann der am erfindungsgemäßen Aufstellfuß angeordnete Stützkörper auch derart gestaltet sein, daß dieser im an der Seitenwand des Gehäuses befestigten Zustand formschlüssig in eine Öffnung der Seitenwand - oder umgekehrt - eingreift. Durch diese erfindungsgemäße Maßnahme ist es möglich, den erfindungsgemäßen Aufstellfuß mit lediglich einer einzigen Schraube oder einem anderen Befestigungsmittel zuverlässig an der Seitenwand des Gehäuses anzubringen, da die Befestigungsschraube oder dergleichen im wesentlichen nur noch gewährleisten muß, daß der am erfindungsgemäßen Aufstellfuß vorgesehene Stützkörper in seiner stützenden bzw. das Gehäuse tragenden Position verbleibt. Durch diese Maßnahme können sowohl die Herstellungskosten als auch die Montagekosten des erfindungsgemäßen Aufstellfußes weiterhin reduziert werden. Zusätzlich ergibt sich der Vorteil, daß der Aufwand des Ummontierens des Aufstellfußes von der Null-Position in eine aufgestellte Position vermindert wird, da nur noch lediglich eine einzige Schraube bzw. ein einziges Befestigungsmittel gelöst und nachfolgend nach dem Ummontieren des erfindungsgemäßen Aufstellfußes erneut festgeschraubt bzw. befestigt werden muß.

Weitere vorteilhafte Ausführungsformen der Erfindung sind in den Unteransprüchen angegeben.

Die Erfindung wird nachfolgend anhand von nicht notwendigerweise maßstäblichen Zeichnungen näher beschrieben, wobei gleiche oder gleich wirkende Teile mit denselben Bezugszeichen versehen sind und darum nicht nochmals näher erläutert werden. Es zeigen:
- Fig. 1: die Seitenwand eines Gehäuses, an der zwei erfindungsgemäße Aufstellfüße jeweils in ihrer Null-Position angebracht sind;
- Fig. 2: die Details eines erfindungsgemäßen Aufstellfußes, der entsprechend Fig. 1 in seiner Null-Position an der Seitenwand des Gehäuses befestigt wird, in Form einer perspektivischen Sprengzeichnung;
- Fig. 3: zwei erfindungsgemäße, an einer Seitenwand eines Gehäuses montierte Aufstellfüße entsprechend der Figuren 1 und 2, wobei jedoch der vordere Aufstellfuß in seiner aufgestellten Position an der Seitenwand des Gehäuses angebracht ist; und
- Fig. 4: die Montage und die Details des an der Seitenwand des Gehäuses befestigten vorderen Aufstellfußes gemäß der Fig. 3 in seiner aufgestellten Position.

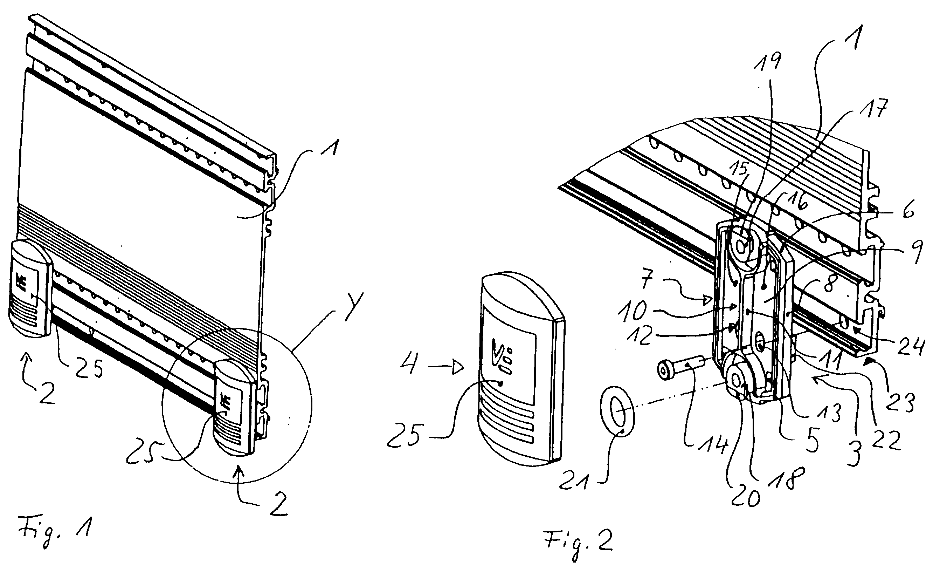

In Fig. 1 ist die Seitenwand eines Gehäuses dargestellt, an dessen Unterseite vorne und hinten jeweils ein erfindungsgemäßer Aufstellfuß 2, jeweils in der Null-Position des Aufstellfußes 2 angebracht sind. Der in Fig. 2 im Detail dargestellte vordere Aufstellfuß 2 der Fig. 1 weist ein Basisteil 3, eine Abdeckkappe 4, eine erste untere Fußfläche 5, eine zweite obere Fußfläche 6, eine erste Seitenwange 7, eine zweite Seitenwange 8, eine erste Ausnehmung 9, eine zweite Ausnehmung 10 und eine zwischen der ersten und zweiten Ausnehmung 9, 10 vorgesehene Trennwand 11 auf. Das Basisteil 3 und die Abdeckkappe 4 bestehen aus Aluminium oder Kunststoff. Das Basisteil des Aufstellfußes 2 weist die Grundform eines Riegels auf, an dessen oberem und unterem Ende abgerundete Fußflächen 5 und 6 angeformt sind. Aufgrund der im Basisteil 3 vorgesehenen Ausnehmungen 9 und 10, zwischen denen sich die Trennwand 11 erstreckt, ergibt sich eine zellartige Struktur für das Basisteil 3, wodurch dieses leicht und mit geringem Materialaufwand herstellbar ist. Im Bereich des oberen Endes des Basisteils 3 ist ein erster nach oben abgeflachter Zapfen 17 und im Bereich des unteren Endes des Basisteils 3 ist ein zweiter, nach unten hin abgeflachter zweiter Zapfen 18 auf dem Basisteil 3 angeformt. Der erste Zapfen 17 und der zweite Zapfen 18 weisen von der Seitenwand 1 des Gehäuses weg. Um einen sicheren Halt eines Gummirings 21 auf dem unteren Zapfen 18 zu gewährleisten, ist der nach unten hin abgeflachte zweite Zapfen 18 mit einer zweiten Führungswand 20 versehen, die an das äußere Ende des Zapfens 18 angeformt ist.

Entsprechend ist der obere erste Zapfen 17 mit einer ersten Führungswand 19 zur Stabilisierung der Lage eines auf den Zapfen 17 aufgeschobenen Gummirings (nicht dargestellt) versehen.

Die erste Ausnehmung 9 ist mit einer ersten Paß-Bohrung 12 und die zweite Ausnehmung 10 mit einer zweiten Paß-Bohrung 13 versehen, die sich jeweils in Richtung auf die Seitenwand 1 des Gehäuses erstrecken. Bei der in Fig. 2 dargestellten Montage des erfindungsgemäßen Aufstellfußes 2 in seiner Null-Position an der Seitenwand 1 des Gehäuses, wird das Basisteil 3 des Aufstellfußes 2 derart an die Seitenwand 1 des Gehäuses angelegt, daß die zweite Paß-Bohrung 13 mit einer am unteren, vorderen Ende der Seitenwand 1 vorgesehenen Gewindebohrung 24 fluchtet. In dieser Stellung des Basisteils 3 untergreift ein an der Rückseite des Basisteils 3 angeformter Stützkörper 22 die Unterfläche 23 der Seitenwand 1. In dieser Stellung wird eine Schraube 14 an das Basisteil 3 des erfindungsgemäßen Aufstellfußes 2 an die dem Durchmesser der Schraube 14 angepaßte Bohrung 13 herangeführt, durchgreift die Bohrung 13 und wird nachfolgend in die Gewindebohrung 24 am unteren vorderen Ende der Seitenwand 1 eingeschraubt, bis das Basisteil 3 zuverlässig an der Seitenwand 1 des Gehäuses befestigt ist. Nachfolgend wird die Abdeckkappe 4 des erfindungsgemäßen Aufstellfußes 2 auf das Basisteil 3 des Aufstellfußes 2 aufgedrückt und verschließt das Basisteil 3 lösbar. Das untere Ende des Gummirings 21, der im montierten Zustand über den zweiten Zapfen 18 geschoben ist, ragt über das untere Ende des Basisteils 3 und das untere Ende der Abdeckkappe 4 hinaus und liegt auf einer Unterlage (nicht dargestellt), auf der das Gehäuse steht, auf.

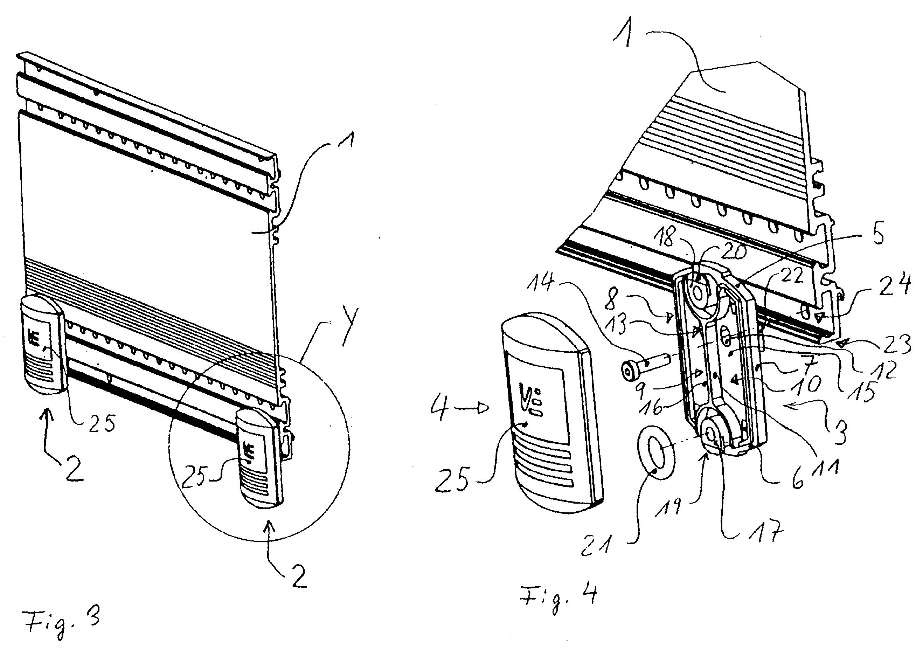

In Fig. 3 ist die Seitenwand 1 des Gehäuses dargestellt, an dessen hinterem, unteren Ende der beschriebene Aufstellfuß 2 in seiner Normal-Position befestigt ist. Am unteren, vorderen Ende der Seitenwand 1 des Gehäuses ist der erfindungsgemäße Aufstellfuß 2 in seiner aufgestellten Position an der Seitenwand 1 des Gehäuses angebracht. Dies ist durch einen Kreis mit der Bezeichnung Y kenntlich gemacht.

Fig. 4 zeigt den vorderen Aufstellfuß in seiner aufgestellten Position bei seiner Montage an der Seitenwand 1 des Gehäuses.

Ein Vergleich der Figuren 2 und 4 zeigt, daß das an sich symmetrische Basisteil 3 des Aufstellfußes 2 um 180° gedreht worden ist und die außermittig zwischen der ersten Fußfläche 5 und der zweiten Fußfläche 6 angeordneten Öffnungen bzw. Paß-Bohrungen 12 und 13 sich nun nicht mehr in ihrer unteren Stellung, sondern in ihrer oberen Stellung befinden. Nach der Montage des erfindungsgemäßen Basisteils 3 in seiner aufgestellten Position an der Seitenwand 1 des Gehäuses stützt sich nunmehr die Unterfläche 23 der Seitenwand 1 im montierten Zustand auf einem Stützkörper 22 ab. Die Montage erfolgt in Analogie zu der im Zusammenhang mit Fig. 2 beschriebenen Weise. Nach Abschluß der Montage des Basisteils 3 des Aufstellfußes 2 in seiner aufgestellten Position weist nunmehr also das in Bezug auf die erste Bohrung 12 und die zweite Bohrung 13 längere Ende des Basisteils bzw. des Aufstellfußes 2 nach unten, wodurch sich eine aufgestellte Position bzw. eine schräg nach oben weisende Stellung des Gehäuses ergibt. Die nach Abschluß der Montage wiederum lösbar auf dem Basisteil 3 aufgeklipste Abdeckkappe 4 ist mit einem Beschriftungsfeld 25 versehen, das vorzugsweise gegenüber der Außenfläche der Abdeckkappe 4 vertieft ist.

Es versteht sich, daß der erfindungsgemäße Aufstellfuß 2 in seinem Auslieferungszustand an einen Kunden bzw. im befestigten Zustand an der Seitenwand des Gehäuses in der beschriebenen Weise sowohl mit einem einzigen Gummiring oder einem anderen, vorzugsweise elastischen Ringkörper oder auch mit zwei Ringkörpern versehen sein kann, wobei jeweils einer der Ringkörper auf die zwei Zapfen aufgeschoben ist. Wird der erfindungsgemäße Gehäusefuß mit zwei auf den Zapfen aufgebrachten Gummiringen oder dergleichen ausgeliefert, oder an der Seitenwand 1 des Gehäuses angebracht, so entfällt bei dem Benutzer des Gehäuses bei der Überführung des Aufstellfußes 2 von seiner Null-Position in eine aufgestellte Position - und umgekehrt - die Notwendigkeit, den ansonsten einzigen Gummiring von dem einen Zapfen zu entfernen und auf den anderen Zapfen aufzuschieben. Zudem steht dann ein Reserve-Gummiring zur Verfügung.

### Bezugszeichenliste

- 1: Seitenwand eines Gehäuses
- 2: Aufstellfuß
- 3: Basisteil des Aufstellfußes 2
- 4: Abdeckkappe des Aufstellfußes 2
- 5: erste Fußfläche
- 6: zweite Fußfläche
- 7: erste Seitenwange
- 8: zweite Seitenwange
- 9: erste Ausnehmung
- 10: zweite Ausnehmung
- 11: Trennwand
- 12: erste Paß-Bohrung
- 13: zweite Paß-Bohrung
- 14: Schraube
- 15: erste Stirnwand
- 16: zweite Stirnwand
- 17: erster Zapfen
- 18: zweiter Zapfen
- 19: erste Führungswand
- 20: zweite Führungswand
- 21: Gummiring
- 22: Stützkörper
- 23: Unterfläche der Seitenwand 1
- 24: Gewindebohrung
- 25: Beschriftungsfeld

## Patentansprüche

1. Aufstellfuß (2) für ein Gehäuse, insbesondere für ein 19"-Tisch-Gehäuse,
**gekennzeichnet durch**
- ein an einer Seitenwand (1) des Gehäuses befestigbares Basisteil (3), wobei
- das Basisteil an seinem oberen Ende eine erste Fußfläche (5) und an seinem unteren Ende eine zweite Fußfläche (6) und
- mindestens eine Öffnung (12, 13) zum Durchgriff eines Befestigungselements (14) zur Befestigung des Basisteils (3) an der Seitenwand (1) des Gehäuses aufweist, wobei
- die Öffnung außermittig zwischen der ersten und der zweiten Fußfläche (5, 6) angeordnet ist.

2. Aufstellfuß nach Anspruch 1,
**dadurch gekennzeichnet,**
daß das Basisteil (3) an seinem oberen und unteren Ende jeweils einen Zapfen (17, 18) aufweist, wobei mindestens der Zapfen am unteren Ende des Basisteils von einem Ringkörper, wie einem Gummiring (21), umschlossen ist und das untere Ende des Ringkörpers das untere Ende des Aufstellfußes (2) bildet.

3. Aufstellfuß nach Anspruch 2,
**dadurch gekennzeichnet,**
daß der Zapfen (17, 18) einstückig an das Basisteil (3) angeformt ist.

4. Aufstellfuß nach einem der Ansprüche 2 bis 3,
**dadurch gekennzeichnet,**
daß sich der Zapfen (17, 18) von der Seitenwand (1) des Gehäuses weg erstreckt.

5. Aufstellfuß nach einem der Ansprüche 1 bis 4,
**dadurch gekennzeichnet,**
daß das Basisteil (3) einen sich in Richtung auf das Gehäuse erstreckenden Stützkörper (22) aufweist, auf dem eine Unterfläche (23) der Seitenwand (1) aufliegt - oder umgekehrt.

6. Aufstellfuß nach einem der Ansprüche 1 bis 4,
**dadurch gekennzeichnet,**
daß das Basisteil (3) einen sich in Richtung auf das Gehäuse erstreckenden Stützkörper aufweist, der formschlüssig in eine Öffnung der Seitenwand eingreift - oder umgekehrt.

7. Aufstellfuß nach einem der Ansprüche 1 bis 6,
**gekennzeichnet durch**
eine auf dem Basisteil (3) befestigbare Abdeckkappe (4).

8. Aufstellfuß nach Anspruch 7,
**dadurch gekennzeichnet,**
daß die Abdeckkappe (4) zumindest im Bereich ihres unteren Endes eine Aussparung aufweist, aus der der Ringkörper (21) herausragt.

9. Aufstellfuß nach einem der Ansprüche 1 bis 8,
**dadurch gekennzeichnet,**
daß das Befestigungselement eine Schraube (14) ist, die die Öffnung (12, 13), vorzugsweise eine der Schraube angepaßte Pass-Bohrung im Basisteil (3), durchgreift und in eine Gewindebohrung (24) der Seitenwand (1) des Gehäuses geschraubt ist.

10. Aufstellfuß nach Anspruch 7 oder 8,
**dadurch gekennzeichnet,**
daß die Abdeckkappe (4) auf ihrer, vom Gehäuse wegweisenden Oberfläche ein Beschriftungsfeld (25) aufweist.
